Europäisches Patentamt

European Patent Office

Office européen des brevets

(11) Publication number: **0 095 379**
**B1**

(12) **EUROPEAN PATENT SPECIFICATION**

(45) Date of publication of patent specification: **01.10.86**

(51) Int. Cl.⁴: **H 03 B 5/36, H 03 L 5/00**

(21) Application number: **83302989.5**

(22) Date of filing: **24.05.83**

(54) Oscillator circuit.

(30) Priorite: **26.05.82 JP 88009/82**

(43) Date of publication of application:
**30.11.83 Bulletin 83/48**

(45) Publication of the grant of the patent:
**01.10.86 Bulletin 86/40**

(84) Designated Contracting States:
**DE FR GB**

(56) References cited:
**DE-A-2 541 352**
**DE-B-1 954 068**
**US-A-3 676 801**
**US-A-4 193 046**

**EDN, vol. 25, no. 21, November 1980, Boston, Massachusetts, USA A.M. HUDOR "FET-controlled crystal yields low distortion", page 201**

**Patent Abstracts of Japan, vol. 5, no. 66, 2 May 1981**

(73) Proprietor: **FUJITSU LIMITED**
**1015, Kamikodanaka Nakahara-ku**
**Kawasaki-shi Kanagawa 211 (JP)**

(72) Inventor: **Fujita, Kouichi**
**1-10-501 Azamino 3-chome**
**Midori-ku Yokohama-shi Kanagawa 227 (JP)**

(74) Representative: **Skone James, Robert Edmund et al**
**GILL JENNINGS & EVERY 53-64 Chancery Lane London WC2A 1HN (GB)**

Courier Press, Leamington Spa, England.

## Description

The present invention relates to an oscillator circuit in a semiconductor integrated circuit, and particularly to an oscillator circuit in which minimum distortion of the waveform of the output signal is required.

In general, in an oscillator circuit constituted in a semiconductor integrated circuit and having a crystal resonator connected externally, the peak-to-peak value of the input signal for the amplifier portion of the oscillator circuit is apt to exceed the voltage range "0–$V_{cc}$" of the voltage source.

EDN, Volume 25, No. 21, November 1980, Boston, Massachusetts, U.S.A. A. M. Hudor "FET-controlled crystal yields low distortion", page 201 describes a feedback oscillator circuit comprising amplifier circuit means having input and output ends and feedback circuit means including a resonator element connected to the output end of the amplifier circuit means for providing a feedback signal for generating an oscillation signal at the output end of the amplifier circuit means. The feedback oscillator circuit includes a FET connected between the input and output end of the amplifier to shunt the feedback path. The voltage applied to the gate of the FET and hence control the conductance of the FET is controlled in dependence upon the voltage appearing at the output end of the amplifier circuit means.

In accordance with one aspect of the present invention, such a feedback oscillator circuit comprising amplifier circuit means constituted by a MOS inverter having input and output ends for generating an oscillation signal at the output end; and feedback circuit means connected to the output end of the amplifier circuit means for generating a feedback signal in response to the oscillation signal, is characterised by gain correction circuit means connected between the input end of the amplifier circuit means, and an output of the feedback circuit means, the gain correction circuit means receiving the feedback signal in use and comprising a voltage division circuit for dividing the feedback signal of the feedback circuit means and for supplying the divided voltage signal to the input end of the amplifier circuit means, the gain correction circuit means being arranged to vary the voltage division ratio of the voltage dividing circuit in accordance with the voltage level of the feedback signal of the feedback circuit means to limit the voltage of the signal fed to the input end of the amplifier circuit means, wherein the voltage division circuit comprises impedance means, operatively connected to the input end of the amplifier circuit means, for providing an impedance to the amplifier circuit means, and a transistor, operatively connected to the impedance means and the feedback circuit means, the transistor having a control input terminal to which the feedback signal of the feedback circuit means is supplied.

In accordance with a second aspect of the present invention an oscillator circuit comprises amplifier circuit means constituted by a MOS inverter having input and output ends for generating an oscillation signal at the output end; and feedback circuit means connected to the output end of the amplifier circuit means for generating a feedback signal in response to the oscillation signal, and is characterised by gain correction circuit means connected between the input end of the amplifier circuit means, and an output of the feedback circuit means, the gain correction circuit means receiving the feedback signal in use and comprising a voltage division circuit for dividing the feedback signal of the feedback circuit means and for supplying the divided voltage to the input end of the amplifier circuit means, the gain correction circuit means being adapted to suppress the feedback signal of the feedback circuit means by changing the voltage division ratio of the voltage dividing circuit in accordance with the voltage level of the output signal of the feedback circuit means when the feedback signal of the feedback circuit means exceeds a predetermined voltage level, wherein the voltage division circuit comprises impedance means, operatively connected to the input end of the amplifier circuit means, for providing an impedance to the amplifier circuit means; and a transistor, operatively connected to the impedance means and the feedback circuit means, the transistor having a control input terminal to which the feedback signal of the feedback circuit means is supplied.

With this invention an improved oscillator circuit is provided capable of generating an oscillation output signal having a duty ratio of about 50%, and requiring no change of the general manufacturing process of the MOS type integrated circuit, whereby an improvement of the characteristic of the oscillator circuit is achieved without increased manufacturing cost.

An example of an oscillator circuit in accordance with the present invention will now be described and contrasted with the prior art with reference to the accompanying drawings, in which:—

Figure 1 illustrates a prior art oscillator circuit;

Figure 2 illustrates the operation characteristic of the oscillator circuit of Figure 1;

Figure 3 illustrates an oscillator circuit according to a preferred embodiment of the present invention; and,

Figures 4 and 5 illustrate the operation characteristic of the oscillator circuit of Figure 3.

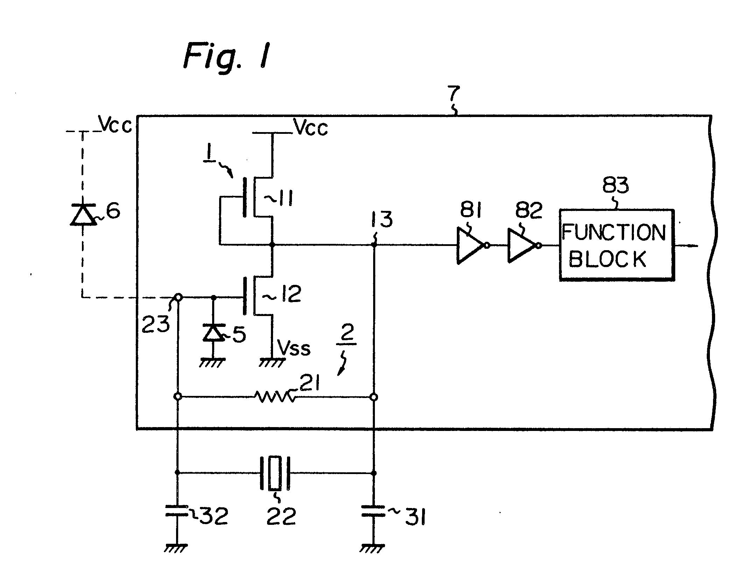

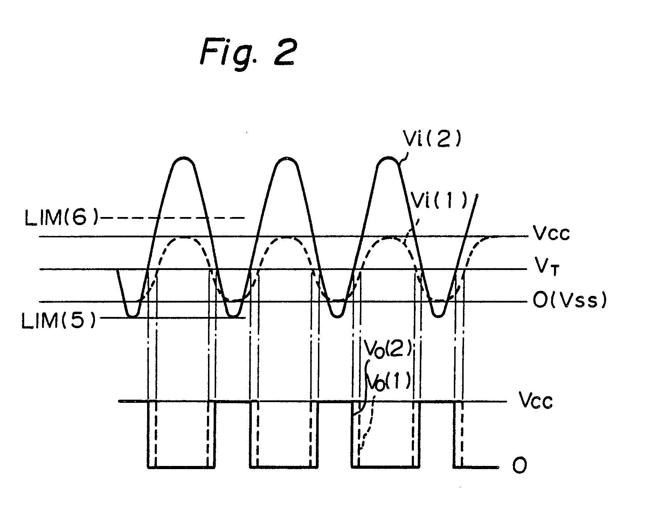

A prior art oscillator circuit will be described with reference to Figures 1 and 2. On a P type semiconductor substrate 7, an amplifier circuit 1, composed of a depletion-type metal-oxide semiconductor (MOS) transistor 11 and an enhancement-type MOS transistor 12, and a feedback resistor 21 are provided. The feedback resistor 21 and a resonator element 22 of a crystal or ceramic type constitute a feedback circuit 2. Capacitors 31 and 32 are connected between the terminals of the resonator element 22 and ground. The output of the oscillator circuit is obtained from the connecting point 13 of the transistors 11 and 12 and is supplied through inverters 81 and 82 to a function block 83 as a timing pulse signal.

The operation characteristic of the oscillator circuit is illustrated in Figure 2. The N-channel MOS transistors 11 and 12 are connected between $V_{CC}$ and $V_{SS}$ (=0).

Under ideal conditions of operation, the waveform of the input signal is shown as $V_i$ (1), which has a peak-to-peak value of $V_{CC}$—$V_{SS}$ and a symmetrical shape of duty ratio of 50% with respect to the level of the threshold voltage $V_T$. The waveform of $V_i$ (1) is either rectangulr or sinusoidal. The waveform of the output signal is shown as $V_0$ (1), which has a peak-to-peak value of $V_{CC}$—$V_{SS}$ and a rectangular shape of duty ratio of 50%.

Under practical conditions of operation, the waveform of the input signal tends to become $V_i$ (2), which is shifted considerably to the upper side to give an asymmetrical shape. Hence, the waveform of the output signal tends to become $V_0$ (2), which is not of duty ratio of 50%.

Although the output of the oscillator circuit of Fig. 1 is supplied through inverters 81 and 82 to a function block 83, such as a microprocessor circuit, such an output signal $V_0(2)$ having a duty ratio significantly less or greater than 50% is unsuitable because the function block 83 is prevented from properly operating.

Hence, the duty ratio of the waveform of the output signal of the oscillator circuit is required to be about 50%. Also, the duty of the waveform of the input signal for the amplifier circuit portion of the oscillator circuit with respect to the input threshold voltage $V_T$ of the amplifier is required to be about 50%. Accordingly, prevention of asymmetry of the input signal for the amplifier portion with respect to the level of the threshold voltage $V_T$ is first required.

In the prior art oscillator circuit, a parasitic diode 5 formed by an N type diffusion region in a P type substrate for forming an input protection circuit (not shown) exists between input node 23 and the gate of the transistor 12, which is connected to the substrate at ground. When the gain of the feedback loop is sufficiently large to cause a large amplitude of the input signal at the input node 23 due to some uncontrollable parasitic reactive elements included in the resonator element 22, the parasitic diode 5 exerts a clamping effect to limit the fall of the waveform of $V_i(2)$ at a portion lower than $V_{SS}$ within a predetermined value LIM(5) corresponding to the forward voltage of the diode 5, as illustrated in Fig. 2. However, the parasitic diode 5 does not exert a clamping effect enough to limit the rise of the waveform of $V_i(2)$ at the upper portion within a predetermined value. Hence, the shape of the waveform of $V_i(2)$ is asymmetrical, as shown in Fig. 2.

To counter the problem of asymmetry of the waveform of $V_i(2)$, it has been contemplated to connect a clamping diode 6 to an input terminal 23 of the amplifier circuit 1. The clamping diode 6 would exert a clamping effect to limit the rise of the waveform of $V_i(2)$ at the upper portion higher than $V_{CC}$ within a predetermined value LIM(6) corresponding to the forward voltage drop of the diode 6, as indicated by the broken line in Figure 2. The clamping diode 6 would improve the situation because it would reduce the asymmetry in the waveform of $V_i(2)$ with respect to $V_T$.

However, the addition of such a clamping diode 6 to the MOS type semiconductor integrated circuit is, in general, considerably difficult from the point of view of the manufacturing process and the MOS type integrated circuit structure. Such addition of a clamping diode 6 to the input terminal 23 of the amplifier circuit 1 in an integrated circuit has not been realized so far. A discrete diode must have been used for this purpose.

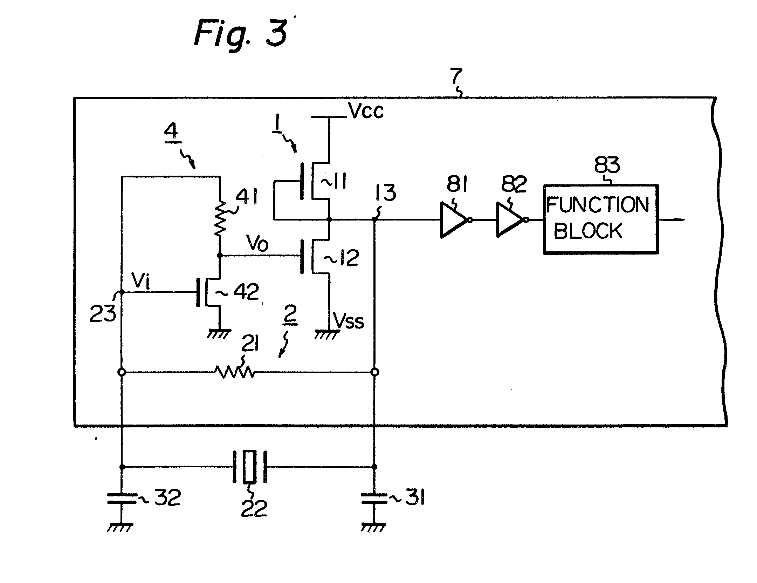

An oscillator circuit according to a preferred embodiment of the present invention is illustrated in Figure 3.

On a P type semiconductor substrate 7, an amplifier circuit 1 composed of a depletion-type MOS transistor 11 and an enhancement type MOS transistor 12, a feedback resistor 21, and a gain correction circuit 4 composed of a diffusion resistance element 41 and an enhancement type MOS transistor 42 are provided. All of the MOS transistors are of N channel type. The feedback resistor 21 and a resonator element 22 of a crystal or ceramic type constitute a feedback circuit 2. Capacitors 31 and 32 are connected between the terminals of the resonator element 22 and ground.

The output of the oscillator circuit is obtained from the connecting point 13 of the transistors 11 and 12 and is supplied through inverters 81 and 82 to a function block 83 of, for example, a frequency division circuit and a succeeding microprocessor circuit.

The diffusion resistance element 41 is a resistance element in form of a diffusion layer in a semiconductor chip in which MOS transistors are formed.

The purpose of the operation of the gain correction circuit 4 is to change the input impedance $Z_i$ in accordance with the change of the input voltage $V_i$ so that the amplitude of the input voltage $V_i$ is suppressed when large. In other words, the circuit 4 controls the feedback gain of the amplifier.

The gate of the transistor 42 is connected to an input terminal 23. A parasitic diode for forming a gate protection element is connected to the input terminal as in the prior art device, through not illustrated in Fig. 3. The source of the transistor 42 is grounded. The diffusion resistance element 41 is connected between the gate and the drain of the transistor 42. The output voltage $V_0$ obtained from the drain of the transistor 42 is supplied to the gate of the transistor 12 in the amplifier circuit 1.

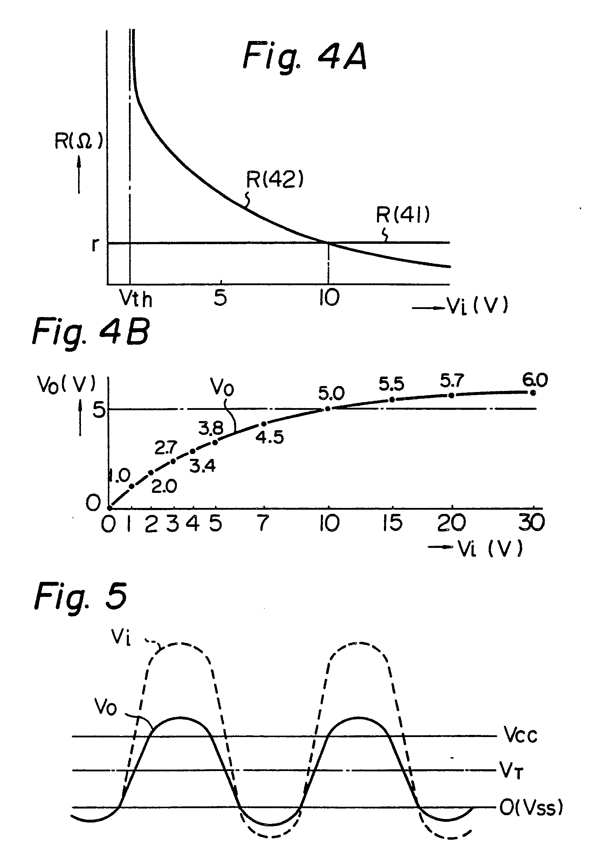

The operation of the oscillator circuit of Fig. 3 is explained with reference to the graph of Figs. 4A and 4B. The graph of Figs. 4A and 4B is based on results of calculations and is verified by the results of experiments carried out by the inventor.

As illustrated by straight line R(41) in Fig. 4A, the resistance r of the diffusion resistance element 41 is constant with respect to the change of the input voltage $V_i$. The resistance R(42) of the transistor 42 is approximately infinite where the input voltage $V_i$ is less than the gate threshold voltage $V_{th}$ of the transistor 42, because the transistor 42 is in the OFF state while the gate voltage $V_i$ of the transistor 42 is less than the gate threshold voltage $V_{th}$.

As the voltage $V_i$ is increased to exceed the voltage $V_{th}$, the drain current of the transistor 42 starts to flow. For example, the circuit is designed such that the resistance R(42) of the transistor 42 is approximately equal to the resistance r of the diffusion resistance element 41 when the voltage $V_i$ is 10 volts.

Under such a condition, the output voltage $V_0$ becomes half of the input voltage $V_i$, i.e., 5 volts. Even if the input voltage $V_i$ is increased to exceed 10 volts, the output voltage $V_0$ does not much exceed 5 volts. The curve $V_0$ represents the relation between $V_0$ and $V_i$ on the basis of the equations set forth below.

The drain current $I_d$ of the transistor 42 is expressed by equation (1), where $V_g$ is the gate voltage, $V_d$ is the drain voltage, and $\beta$ is a predetermined constant:

$$I_d = \beta[(V_g - V_{th})V_d - \frac{1}{2}V_d^2] \qquad (1)$$

in the triode range, where $V_g > V_d$, of a MOS transistor. Accordingly, equation (2) is expressed as follows with regard to the MOS transistor 42 in the circuit of Fig. 3.

$$I_d = \beta[(V_i - V_{th})V_0 - \frac{.1}{2}V_0^2] \qquad (2)$$

The current $I_r$ through the diffusion resistance element 41 is expressed as equation (3) below.

$$I_r = (V_i - V_0)/r \qquad (3)$$

From equations (2) and (3) and the fact that $I_d$ is equal to $I_r$, equation (4) representing the relation between $V_0$ and $V_i$ is obtained.

$$V_0 = \frac{1}{\beta r} + V_i - V_{th} - \sqrt{(\frac{1}{\beta r} + V_i - V_{th})^2 - \frac{2V_i}{\beta r}} \qquad (4)$$

By calculating the value $V_0$ according to equation (4) under the conditions that the gate threshold voltage $V_{th}$ is 1 volt and that $V_0$ is 5 volts when $V_i$ is 10 volts, the curve $V_0$ in Fig. 4B is obtained. The curve $V_0$ in Fig. 4B has been verified by the results of experiments carried out by the inventor.

Thus, in the oscillator device of Fig. 3, the voltage $V_0$ is limited within approximately 5 volts even when the voltage $V_i$ exceeds 10 volts, as illustrated in Fig. 5. Hence, the output signal having the waveform of the duty ratio of 50% is obtained at the point 13 in the output line of the amplifier circuit 1.

Although N-channel MOS transistors are used for the amplifier circuit portion of the oscillator device of Fig. 3, it is also possible to use P-channel MOS transistors.

## Claims

1. A feedback oscillator circuit comprising amplifier circuit means (1) constituted by a MOS inverter having input and output ends for generating an oscillation signal at the output end (13); and feedback circuit means (2) connected to the output end (13) of the amplifier circuit means (1) for generating a feedback signal in response to the oscillation signal, characterised by gain correction circuit means (4) connected between the input end of the amplifier circuit means (1) and an output of the feedback circuit means (2), the gain correction circuit means (4) receiving the feedback signal in use and comprising a voltage division circuit (41, 42) for dividing the feedback signal of the feedback circuit means (2) and for supplying the divided voltage signal to the input end of the amplifier circuit means (1), the gain correction circuit means (4) being arranged to vary the voltage division ratio of the voltage dividing circuit (41, 42) in accordance with the voltage level of the feedback signal of the feedback circuit means (2) to limit the voltage of the signal fed to the input end of the amplifier circuit means (1), wherein the voltage division circuit comprises impedance means (41), operatively connected to the input end of the amplifier circuit means (1), for providing an impedance to the amplifier circuit means, and a transistor (42), operatively connected to the impedance means (41) and the feedback circuit means (2), the transistor having a control input terminal to which the feedback signal of the feedback circuit means is supplied.

2. An oscillator circuit comprising amplifier circuit means (1) constituted by a MOS inverter having input and output ends for generating an oscillation signal at the output end (13); and feedback circuit means (2) connected to the output end (13) of the amplifier circuit means (1) for generating a feedback signal in respomse to the oscillation signal, characterised by gain correction circuit means (4) connected between the input end of the amplifier circuit means (1), and an output of the feedback circuit means (2), the gain correction circuit means (4) receiving the feedback signal in use and comprising a voltage division circuit (41, 42) for dividing the feedback signal of the feedback circuit means (2) and for supplying the divided voltage to the input end of the amplifier circuit means (1) the gain correction circuit means (4) being adapted to suppress the feedback signal of the feedback circuit means (2) by changing the voltage division ratio of the voltage dividing circuit (41, 42) in accordance with the voltage level of the output signal of the feedback circuit means (2) when the feedback signal of the feedback circuit means (2) exceeds a predetermined voltage level, wherein the voltage division circuit comprises impedance means (41), operatively connected to the input end of the amplifier circuit means (1), for providing an impedance to the amplifier circuit means, and a transistor (42), operatively connected to the impedance means (41) and the feedback circuit means (2), the transistor having a control input terminal to which the feedback signal of the feedback circuit means is supplied.

3. An oscillator circuit according to claim 1 or claim 2, wherein the impedance means comprises a resistance which is connected to a drain of the transistor (42), and wherein a source of the transistor is connected to ground, and the output signal from the feedback circuit means (2) is supplied to a gate of the transistor.

**Patentansprüche**

1. Rückgekoppelte Oszillatorschaltung mit einer Verstärkerschaltungseinrichtung (1), die aus einem MOS-Inverter besteht, der Eingangs- und Ausgangsenden zur Erzeugung eines Oszillationssignals an dem Ausgangsende (13) hat; und einer Rückkopplungsschaltungseinrichtung (2), die mit dem Ausgangsende (13) der Verstärkerschaltungseinrichtung (1) zur Erzeugung eines Rückkopplungssignals in Abhängigkeit von dem Oszillationssignal angeschlossen ist, gekennzeichnet durch eine Verstärkungskorrekturschaltungseinrichtung (4), die zwischen dem Eingangsende der Verstärkerschaltungseinrichtung (1) und einem Ausgang der Rückkopplungsschaltungseinrichtung (2) angeschlossen ist, wobei die Verstärkungskorrekturschaltungseinrichtung (4) das Rückkopplungssignal im Betrieb empfängt, und eine Spannungsteilerschaltung (41, 42) umfaßt, zur Teilung des Rückkopplungssignals der Rückkopplungsschaltungseinrichtung (2) und zur Zuführung des geteilten Spannungssignals zu dem Eingangsende der Verstärkerschaltungseinrichtung (1) empfängt, wobei die Verstärkungskorrekturschaltungseinrichtung (4) angeordnet ist, um das Spannungsteilungsverhältnis der Spannungsteilerschaltung (41, 42) in Übereinstimmung mit einem Spannungspegel des Rückkopplungssignals der Rückkopplungsschaltungseinrichtung (2) zu variieren, um die Spannung des Signals zu begrenzen, welches dem Eingangsende der Verstärkerschaltungseinrichtung (1) zugeführt wird, wobei die Spannungsteilerschaltung eine Impedanzeinrichtung (41) umfaßt, die wirkungsmäßig mit dem Eingangsende der Verstärkerschaltungseinrichtung (1) verbunden ist, um eine Impedanz für die Verstärkerschaltungseinrichtung zu bilden, und einen Transistor (42), der wirkungsmäßig mit der Impedanzeinrichtung (41) und der Rückkopplungsschaltungseinrichtung (2) verbunden ist und der einen Steuereingangsanschluß hat, dem das Rückkopplungssignal der Rückkopplungsschaltungseinrichtung zugeführt wird.

2. Oszillatorschaltung mit einer Verstärkerschaltungseinrichtung (1), die aus einem MOS-Inverter besteht, der Eingangs- und Ausgangsenden zur Erzeugung eines Oszillationssignals an dem Ausgangsende (13) hat; und einer Rückkopplungsschaltungseinrichtung (2), die mit dem Ausgangsende (13) der Verstärkerschaltungseinrichtung (1) zur Erzeugung eines Rückkopplungssignals in Abhängigkeit von dem Oszillationssignal angeschlossen ist, gekennzeichnet durch eine Verstärkungskorrekturschaltungseinrichtung (4), die zwischen dem Eingangsende der Verstärkerschaltungseinrichtung (1) und einem Ausgang der Rückkopplungsschaltungseinrichtung (2) angeschlossen ist, wobei die Verstärkungskorrekturschaltungseinrichtung (4) das Rückkopplungssignal im Betrieb empfängt und eine Spannungsteilerschaltung (41, 42) umfaßt, zur Teilung des Rückkopplungssignals der Rückkopplungsschaltungseinrichtung (2) und zur Zuführung des geteilten Spannungssignals zu dem Eingangsende der Verstärkerschaltungseinrichtung (1), wobei die Verstärkungskorrekturschaltungseinrichtung (4) angepaßt ist, um das Rückkopplungssignal der Rückkopplungsschaltungseinrichtung (2) zu unterdrücken, durch Veränderung des Spannungsteilerverhältnisses der Spannungsteilerschaltung (41, 42), in Übereinstimmung mit dem Spannungspegel des Ausgangssignals der Rückkopplungsschaltungseinrichtung (2), wenn das Rückkopplungssignal der Rückkopplungsschaltungseinrichtung (2) einen vorbestimmten Spannungspegel überschreitet, wobei die Spannungsteilerschaltung eine Impedanzeinrichtung (41) umfaßt, die wirkungsmäßig mit dem Eingangsende der Verstärkerschaltungseinrichtung (1) verbunden ist, um eine Impedanz für die Verstärkerschaltungseinrichtung zu bilden, und einen Transistor (42), der wirkungsmäßig mit der Impedanzeinrichtung (41) und der Rückkopplungsschaltungseinrichtung (2) verbunden ist, wobei der Transistor einen Steuereingangsanschluß hat, dem das Rückkopplungssignal der Rückkopplungsschaltungseinrichtung zugeführt wird.

3. Oszillatorschaltung nach Anspruch 1 oder 2, bei welcher die Impedanzeinrichtung einen Widerstand umfaßt, der mit einem Drain des Transistors (42) verbunden ist, und bei welcher eine Source des Transistors mit Erde verbunden ist und das Ausgangssignal der Rückkopplungsschaltungseinrichtung (2) einem Gate des Transistors zugeführt wird.

**Revendications**

1. Circuit oscillant à réaction comprenant un circuit amplificateur (1) constitué par un inverseur MOS possédant des extrémités d'entrée et de sortie servant à produire un signal d'oscillation sur une extrémité de sortie (13) et un circuit de réaction (2) connecté à l'extrémité de sortie (13) du circuit amplificateur (1) pour produire un signal de réaction en réponse au signal d'oscillation, caractérisé par un circuit de correction de gain (4) connecté entre l'extrémité d'entrée du circuit amplificateur (1) et une sortie du circuit de réaction (2), le circuit de correction de gain (4) recevant le signal de réaction en utilisation et comprenant un circuit diviseur de tension (41, 42) qui divise le signal de réaction du circuit de réaction (2) et délivre le signal de tension divisée à l'extrémité d'entrée du circuit amplificateur (1), le circuit de correction de gain (4) étant conçu pour fair varier le rapport de division de tension du circuit diviseur de tension (41, 42) en fonction du niveau de tension du signal de réaction du circuit de réaction (2) afin de limiter la tension du signal délivré à l'extrémité d'entrée du circuit amplificateur (1), où le circuit diviseur de tension comprend un moyen à impédance (41) fonctionellement connecté à l'extrémité d'entrée du circuit amplificateur (1), servant à fournir une impédance au circuit amplificateur, et un transistor (42) fonctionnellement connecté au moyen à impédance (41) et au circuit de réaction (2), le transistor possédant une borne d'entrée de commande à laquelle le signal de réaction du circuit de réaction est délivré.

2. Circuit oscillant comprenant un circuit amplificateur (1) constitué par un inverseur MOS possédant des extrémités d'entrée et de sortie afin de produire un signal d'oscillation sur l'extrémité de sortie (13) et un circuit de réaction (2) connecté à l'extrémité de sortie (13) du circuit amplificateur (1) afin de produire un signal de réaction en réponse au signal d'oscillation, caractérisé par un circuit de correction de gain (4) connecté entre l'extrémité d'entrée du circuit amplificateur (1) et une sortie du circuit de réaction (2), le circuit de correction de gain (4) recevant le signal de réaction en utilisation et comprenant un circuit diviseur de tension (41, 42) qui divise le signal de réaction du circuit de réaction (2) et délivre la tension divisée à l'extrémité d'entrée du circuit amplificateur (1), le circuit de correction de gain (4) étant conçu pour supprimer le signal de réaction du circuit de réaction (2) en modifiant le rapport de division de tension du circuit diviseur de tension (41, 42) en fonction du niveau de tension du signal de sortie du circuit de réaction (2) lorsque le signal de réaction du circuit de réaction (2) dépasse un niveau de tension prédéterminé, où le circuit diviseur de tension comprend un moyen à impédance (41) fonctionnellement connecté à l'extrémité d'entrée du circuit amplificateur (1), afin de fournir une impédance au circuit amplificateur, et un transistor (42) fonctionnellement connecté au moyen à impédance (41) et au circuit de réaction (2), le transistor possédant une borne d'entrée de commande à laquelle le signal de réaction du circuit de réaction est délivré.

3. Circuit oscillant selon la revendication 1 ou 2, où le moyen à impédance comprend une résistance qui est connectée à un drain du transistor (42), et où une source du transistor est connectée à la terre, le signal de sortie du circuit de réaction (2) étant délivré à une grille du transistor.

Fig. 1

0 095 379

# Fig. 2

# Fig. 3

# Fig. 4A

# Fig. 4B

# Fig. 5

4